# EUROPEAN PATENT SPECIFICATION

(11) **EP 0 399 820 B1**
(45) Date of publication and mention of the grant of the patent: **08.02.1995**
(21) Application number: 90305649.7
(22) Date of filing: 24.05.1990
(51) Int. Cl.: G11C 7/00, G11C 7/06, G11C 16/06

(54) **Semiconductor memories**
Halbleiterspeicher
Mémoires à semi-conducteurs

(30) Priority: 25.05.1989 JP 134120/89
(43) Date of publication of application: 28.11.1990
(73) Proprietor: SONY CORPORATION, Tokyo 141 (JP)
(72) Inventor: Mochizuki, Hidenobu, c/o Patent Division, Shinagawa-ku, Tokyo (JP)
(74) Representative: Thomas, Christopher Hugo

(56) References cited:
- IEEE JOURNAL OF SOLID-STATE CIRCUITS.vol. SC-17, no. 5, October1982, NEW YORK, US pages 841 - 846; R.G. STEWART ET AL.: 'A 40ns CMOS E2PROM'
- PATENT ABSTRACTS OF JAPAN vol. 5, no. 182 (P-90)(854) 20November 1981 & JP-A-56 111 188 ( TOKYO SHIBAURA DENKI ) 2 September 1981
- PATENT ABSTRACTS OF JAPAN vol. 2, no. 108 (E-78)8September 1978
- & JP-A-53 074 328 ( TOKYO SHIBAURA DENKI ) 7 January 1978
- IEEE JOURNAL OF SOLID-STATE CIRCUITS. vol. SC-15, no. 3, June 1980,NEW YORK, US pages 346 - 353; T. HAGIWARA ET AL.: 'A 16 kbit electricallyerasable PROM using n-channel Si-gate MNOS technology.'

## Description

This invention relates to semiconductor memories. More particularly, the invention relates to memories comprising a memory cell including an MOS transistor connected between a bit line and a reference potential terminal, and means for reading out the contents of the memory cell.

Known read only memories (ROMs) are classifiable into two types: (1) where an ordinary cell and a dummy cell are provided, and a difference in potential between bit lines associated with the two cells is detected by a differential amplifier; and (2) where no dummy cell is provided, and the bit line potential of the only cell is read out after being amplified by an inverter.

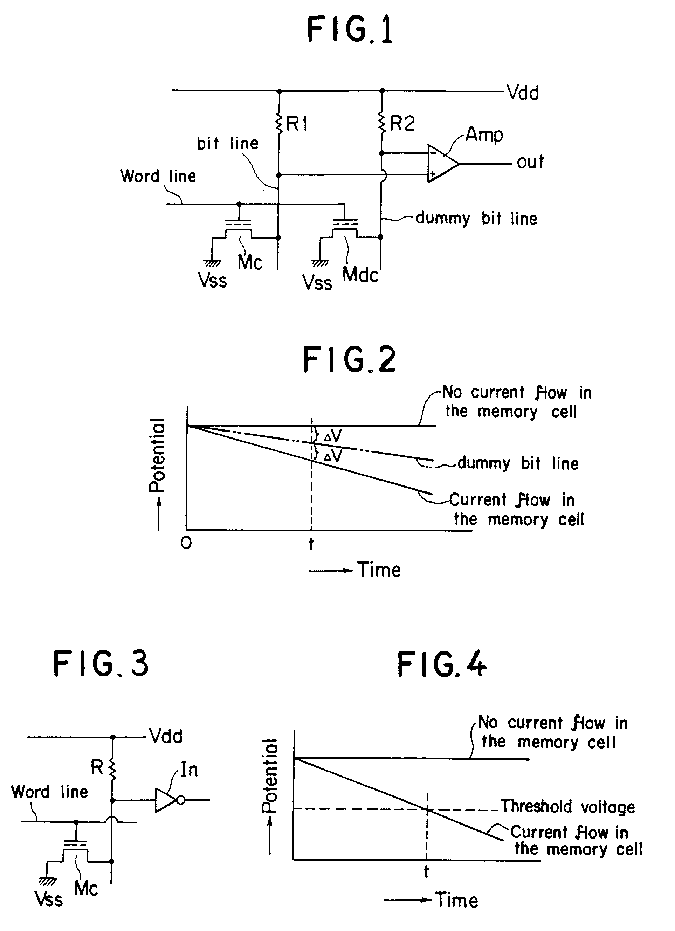

Figure 1 is a circuit diagram of a known ROM of the first type. The ordinary cell comprises an MOS transistor Mc having a source coupled to earth potential Vss, and a drain coupled to an ordinary bit line. The dummy cell comprises an MOS transistor Mdc having its source coupled to earth potential Vss, and a drain coupled to a dummy bit line.

A load resistor R1 is connected between the ordinary bit line and a power terminal having potential Vdd. A load resistor R2 is connected between the dummy bit line and the power terminal. A differential amplifier AMP having one input coupled to the ordinary bit line, and another input coupled to the dummy bit line effects a comparison between the potentials of the bit lines.

In this circuit, the current drive of the MOS transistor Mdc is normally set to half the current drive of the MOS transistor Mc. Additionally, the load resistor R2 can be set to half the value of the load resistor R1.

In either case, the potential drop caused in the ordinary bit line by the flow of a current in the ordinary cell is faster than that in the dummy bit line. This is illustrated in Figure 2, which is a graph showing how the various bit line potentials of the memory of Figure 1 vary over time. Under the conditions including the sensitivity ΔV of the amplifier AMP, and the time t required for inducing a potential difference ΔV between the dummy bit line and the ordinary bit line, it follows that the time t is required for identifying the state of the memory cell.

Figure 3 is a circuit diagram of a known ROM of the second type, comprising a sense amplifier that amplifies the bit line potential via an inverter, without the provision of a dummy cell. There is included an inverter In, and a load resistor R connected between the ordinary bit line and the power terminal. The potential of the bit line is read out via the inverter In.

Figure 4 is a graph illustrating how the potential in the bit line of the memory of Figure 3 varies over time. It can be appreciated that in this circuit, when a current flows in the memory cell, the time required for reading out the potential is longer by the time period t needed for the bit-line potential to traverse the threshold voltage of the inverter In after initiation of its change.

There exists a great demand for increasing the read-out speed of a semiconductor memory such as a ROM. However, it has been difficult to meet this demand using circuits as shown in Figures 1 and 3.

In the circuit of Figure 1, instead of a direct detection of the rapid potential change in the ordinary bit line current flow through the cell, there is a detection of the potential difference between the ordinary bit line and the dummy bit line where the speed of potential change is as low as half the value in the ordinary bit line, so that the time required for reading out such potential change is twice that in the case of direct detection, assuming the sensitivity of the amplifiers to be the same.

Likewise, in the circuit of Figure 3, a considerable amount of time is needed to execute a memory read-out.

IEEE Journal of Solid-State Circuits, Vol. SC-17, No. 5, Oct. 1982, P. 841-846 describes a semiconductor memory, comprising: a memory cell comprising a MOS transistor connected between a bit line and a reference potential terminal; a sensing amplifier having an input coupled to said bit line for reading out a potential on said bit line, and an output, said sensing amplifier comprising an inverter with its input and output connected to each other via a switch; and a circuit element operative to transmit changes of the potential on said bit line, connected between said bit line and said sensing amplifier. In the arrangement described in that publication, the circuit element is a transmission gate controlled by the bit line and an inverse bit line. Also, Patent Abstracts of Japan, Vol. 5, No. 182 (P-90)(845), 20 Nov. 1981, includes an abstract of JP-A-56/111,188 in which an input to a sensing amplifier is pre-charged to a level near the threshold level thereof and a bit line is coupled to the sensing amplifier input by a capacitor.

The present invention is characterised in that the circuit element which is operative to transmit changes of the potential on the bit line functions substantially as a junction diode.

Preferably, said circuit element operative to transmit bit line potential changes, transmits a potential change only when the change is in the direction of the reference potential.

The input level of the inverter can be biased to its threshold voltage by momentarily turning on the switching means before the start of a memory read operation. When the bit line reference potential is changed after the memory cell has been placed in its "on" state to cause flow of a current, the input level of the inverter is changed from the threshold voltage towards the reference potential, so that the inverter is immediately set for generating an output signal corresponding to the stored content of the memory cell. Consequently, it is possible to provide a short time for achieving an identifiable state of the memory cell and, hence, to speed up the read operation.

The invention will now be described by way of example with reference to the accompanying drawings, throughout which like parts are referred to by like references, and in which:
Figures 1 and 3 are circuit diagrams of known semiconductor memories;
Figure 2 is a graph showing how a bit line potential of the memory of Figure 1 varies over time;
Figure 4 is a graph showing how a bit line potential of the memory of Figure 3 varies over time; and
Figure 5 is a circuit diagram of an embodiment of semiconductor memory according to the present invention.

Embodiments of the invention can provide an increased read-out speed. To that end, a semiconductor memory is provided with an inverter having an input coupled to a bit line of the memory, the inverter including an output coupled to the input via a switch. Moreover, an element capable of transmitting changes in potential only is interposed between the input of the inverter and the bit line, so that only potential changes are transmitted to the inverter.

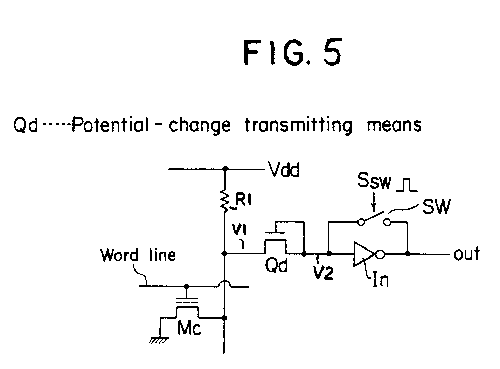

Referring to Figure 5, an inverter In has an input coupled to a bit line of the memory cell so as to serve as a sensing amplifier. As illustrated, input and output terminals of the inverter In are coupled together via a switching means Sw. A potential change transmitting element Qd is interposed between the input terminal of the inverter In and the bit line. In all other respects, the memory is substantially similar to that of Figure 3.

In the embodiment, a junction diode is used as the potential change transmitting means. To this end, an MOS transistor Qd is connected between the memory cell bit line and the inverter In, and its gate is connected to an anode of the MOS transistor Qd and the inverter In. The MOS transistor Qd functions substantially as a diode, whose anode and cathode are on the inverter side and the bit line side, respectively.

The switching means Sw is momentarily turned on (closed) before the start of a memory read operation by a signal Ssw generated in response to an address transition detection signal. When the switching means Sw is momentarily turned on, the input and output terminals of the inverter In are short-circuited, so that a potential V2 at the input terminal of the inverter In is substantially equal to a threshold voltage Vth of the inverter In. The inverter threshold voltage can be equal to, for example, 1/2 Vdd.

When the switching means sw is turned on to bias the input level of the inverter In to the inverter threshold voltage Vth, and is then immediately turned off, the bit line will be at the Vdd level and therefore the diode comprising the MOS transistor Qd will be turned off. Consequently, the input level of the inverter In remains unchanged at the threshold level Vth.

When a word signal is input in this state by application of a signal to the gate of the transistor Mc, a current flows in the memory cell. The current flows from the resistor R1 to earth through the transistor Mc. As a result, a potential V1 on the bit line is lowered because the bit line is coupled to earth. When the bit line potential is reduced after the start of a read operation, the diode turns on to reduce the input potential of the inverter In from the threshold voltage Vth. Consequently, the output of the inverter In is immediately changed to be at the level of the state of the memory cell (to a high level when the cell is turned on), whereby the reading operation can be expedited.

## Claims

1. A semiconductor memory, comprising:
a memory cell comprising a MOS transistor (Mc) connected between a bit line and a reference potential terminal;
a sensing amplifier (In) having an input coupled to said bit line for reading out a potential on said bit line, and an output, said sensing amplifier (In) comprising an inverter (In) with its input and output connected to each other via a switch (sw); and
a circuit element (Qd) operative to transmit changes of the potential on said bit line, connected between said bit line and said sensing amplifier (In);
characterised in that said circuit element (Qd) functions substantially as a junction diode.

2. A memory according to claim 1 wherein said circuit element (Qd) operative to transmit bit line potential changes, transmits a potential change only when the change is in the direction of the reference potential.

## Patentansprüche

1. Halbleiterspeicher, mit
einer Speicherzelle mit einem MOS-Transistor (Mc), die zwischen einer Bitleitung und einem Bezugspotentialanschluß geschaltet ist;
einem Leseverstärker (In), der einen Eingangsanschluß hat, der mit der Bitleitung verbunden ist, um ein Potential auf der Bitleitung zu lesen, und einen Ausgangsanschluß, wobei der Eingangs- und Ausgangsanschluß des Leseverstärkers (In), der einen Inverter (In) aufweist, miteinander über einen Schalter (sw) verbunden sind; und
einem Schaltungselement (Qd), das die Änderungen des Potentials auf der Bitleitung übertragen kann, das zwischen der Bitleitung und dem Leseverstärker (In) geschaltet ist;
**dadurch gekennzeichnet**, daß das Schaltungselement (Qd) im wesentlichen als Flächendiode arbeitet.

2. Speicher nach Anspruch 1, wobei das Schaltungselement (Qd), das die Bitleitungs-Potentialänderungen übertragen kann, eine Potentialänderung nur dann überträgt, wenn die Änderung in der Richtung des Bezugspotentials verläuft.

## Revendications

1. Mémoire à semiconducteurs, comprenant :
une cellule de mémoire comprenant un transistor à métal-oxyde-semiconducteur MOS (Mc) connecté entre un fil de bit et une borne de potentiel de référence ;
un amplificateur de détection (In) ayant une entrée couplée audit fil de bit pour lire un potentiel sur ledit fil de bit, et une sortie, ledit amplificateur de détection (In) comprenant un inverseur (In) dont l'entrée et la sortie sont connectées entre elles par un commutateur (Sw) ; et,
un élément de circuit (Qd) agissant pour transmettre les variations du potentiel sur ledit fil de bit, connecté entre ledit fil de bit et ledit amplificateur de détection (In) ;
caractérisée en ce que ledit élément de circuit (Qd) fonctionne essentiellement comme une diode à jonction.

2. Mémoire selon la revendication 1, dans laquelle ledit élément de circuit (Qd) agissant pour transmettre les variations de potentiel du fil de bit, ne transmet une variation de potentiel que lorsque cette variation est dans le sens du potentiel de référence.
